# EUROPÄISCHE PATENTSCHRIFT

(11) **EP 0 714 130 B1**
(45) Veröffentlichungstag und Bekanntmachung des Hinweises auf die Patenterteilung: **30.01.2002**
(21) Anmeldenummer: 95117256.8
(22) Anmeldetag: 02.11.1995
(51) Int. Cl.: H01L 25/065

(54) **Verfahren zur Herstellung einer Anordnung zur kapazitiven Signalübertragung zwischen den Chiplagen einer vertikal integrierten Schaltung**
Method of manufacturing a capacitive signal transfer device between the chip layers of a vertical integrated circuit
Procédé de fabrication d'un dispositif de transfert capacitif de signaux entre les couches de puce d'un circuit intégré vertical

(30) Priorität: 15.11.1994 DE 4440866
(43) Veröffentlichungstag der Anmeldung: 29.05.1996
(73) Patentinhaber: Infineon Technologies AG, 81669 München (DE)
(72) Erfinder: Weber, Werner, Dr., D-80637 München (DE); Kühn, Stefan, D-80545 München (DE); Kleiner, Michael, D-81373 München (DE); Thewes, Roland, D-82178 Puchheim (DE)
(74) Vertreter: Zedlitz, Peter, Dipl.-Inf.

(56) Entgegenhaltungen:
- EP-A- 0 073 486
- EP-A- 0 206 696
- DE-A- 2 902 002
- DE-C- 4 314 907
- GB-A- 2 253 308

## Beschreibung

Die Erfindung betrifft ein Herstellverfahren nach dem Oberbegriff des Patentanspruchs 1.

Integrierte Schaltungen werden heute überwiegend in Planartechnik hergestellt. Die erreichbare Komplexität auf einem einzelnen Halbleiterchip ist jedoch begrenzt durch dessen Abmessungen und durch die zu dessen Herstellung verwendete Prozeßtechnologie.

Zur Steigerung der Leistungsfähigkeit werden zur Zeit Ansätze verfolgt, bei denen mehrere Lagen von Halbleiterchips vertikal integriert, d.h. übereinander angeordnet und elektrisch verbunden werden. Bei vertikal integrierten Schaltungen, die im folgenden kurz VICs genannt werden, besteht eine dreidimensionale Schaltungsstruktur aus einem Stapel unabhängig voneinander prozessierter Einzelchiplagen, die in der Regel mit Klebeschichten verbunden werden. Die einzelnen Chiplagen können dazu vor dem Zusammenbau auf eine entsprechende Dicke "heruntergedünnt", d. h. heruntergeätzt oder heruntergeschliffen werden, um gute elektrische Eigenschaften und eine hohe Verbindungsdichte zu gewährleisten. Bei SOI-Technologien (Silcon on Insulator) bietet sich das vergrabene Oxid als Ätzstop für das "Dünnen" der Scheiben an. Bei konventionellen Silizium-Technologien kann das Substrat bis zum Feldoxid von in einer Chiplage enthaltenen MOSFETs heruntergedünnt sein oder aber noch eine wenige µm dicke Substratschicht an der Unterseite der Chiplagen aufweisen.

Aus der Veröffentlichung Williams R., Marsh O., "Future WSI technology: stacked monolithic WSI", IEEE Transactions on CHMT, vol. 16, No.7, pp.610-614. ist beispielsweise eine Anordnung zur galvanischen Signalübertragung zwischen den Chiplagen einer vertikal integrierten Schaltung bekannt. Dabei sind relativ dünne Chiplagen mit einer Dicke von ca. 10 µm und feine metallische Verbindungen mit einem Durchmesser von ca. 1 µm erforderlich, um, insbesondere bei hohen Verbindungsdichten, gute elektrische Eigenschaften der vertikalen Signalverbindungen zu gewährleisten. Ein wesentlicher Nachteil besteht hierbei jedoch darin, daß extrem hohe Anforderungen an die Justierung der Chiplagen zueinander und an die Planarität der Chipoberflächen zu stellen sind.

In jüngerer Zeit wurden deshalb, beispielsweise in der Veröffentlichung Val C., Leroy M., "The 3D interconnection - applications for mass memories and microprocessors", Proc. 24th Symp. on ISHM, 1991, pp.62-68, Anordnungen vorgeschlagen, bei denen die Verbindungen von Chiplage zu Chiplage über die Seitenflächen geführt werden, dies birgt jedoch den Nachteil, daß die vertikalen Verbindungen zum einen nicht frei plazierbar und zum anderen um Größenordnungen länger sind als bei den obengenannten VICs.

Die Merkmale des Oberbegriffs des Patentanspruchs 1 ist aus der deutschen Offenlegungsschrift 29 02 002 bekannt.

Die der Erfindung zugrundeliegende Aufgabe liegt nun darin, ein Verfahren zur Herstellung einer Anordnung zur Signalübertragung zwischen den Chiplagen einer vertikal integrierten Schaltung anzugeben, bei der eine große Anzahl frei plazierbarer und zuverlässiger vertikaler Signalverbindungen direkt vom Inneren einer Chiplage zum Inneren einer benachbarten Chiplage bestehen, obwohl diese Anordnung ohne extrem hohe Anforderungen an die Justierung der Chiplagen zueinander und an die Planarität der Chipoberflächen herstellbar ist.

Diese Aufgabe wird erfindungsgemäß durch die im Patentanspruch 1 angegebenen Merkmale gelöst.

Die mit der Erfindung erzielten Vorteile liegen insbesondere darin, daß die Empfangseinrichtungen so ausgelegt werden können, daß sie für einen relativ großen Bereich der Koppelkapazität sicher funktionieren, daß die Signalübertragung auch dann sicher funktioniert, wenn Oberflächenwelligkeiten der Chiplagen und Unregelmäßigkeiten des Interlayerdielektrikums den Elektrodenabstand und damit die Koppelkapazität verändern oder wenn im Extremfall die Elektroden sogar kurzgeschlossen sind, daß die Elektroden durch geeignete Dimensionierung tolerant gegenüber etwaigen lateralen Versatzen ausgelegt werden können, daß die Sender- und Empfängerschaltungen ein direktes kontaktloses Testen einzelner Chiplagen ermöglichen, daß innovative und aufwendige Prozeßschritte zur Herstellung der galvanischen Interchipverbindungen bei der kontaktlosen Signalübertragung vermieden werden können und daß die Signalübertragung ohne wesentliche Beeinträchtigung der Bandbreite erfolgt.

Die Erfindung wird nachfolgend anhand der Zeichnungen näher erläutert. Dabei zeigt
- Figur 1: eine Darstellung zweier benachbarter Chiplagen einer vertikal integrierten Schaltung mit einer erfindungsgemäßen Anordnung ,
- Figur 2: ein dreifaches Spannungs/Zeit-Diagramm zur Erläuterung der Anordnung von Fig. 1,
- Figur 3a: eine erste Ausführungsform einer Koppelkapazität einer erfindungsgemäßen Anordnung,
- Figur 3b: eine zweite Ausführungsform einer Koppelkapazität einer erfindungsgemäßen Anordnung,
- Figur 3c: eine dritte Ausführungsform einer Koppelkapazität einer erfindungsgemäßen Anordnung,
- Figur 4a: ein Blockschaltbild einer erfindungsgemäßen Anordnung mit einer ersten Ausführungsform einer Empfangseinrichtung
- Figur 4b: ein Blockschaltbild einer erfindungsgemäßen Anordnung mit einer zweiten Ausführungsform einer Empfangseinrichtung
- Figur 5a: eine Detailschaltung einer Empfangseinrichtung nach Figur 4a und.
- Figur 5b: eine Detailschaltung einer Empfangseinrichtung nach Figur 4b.

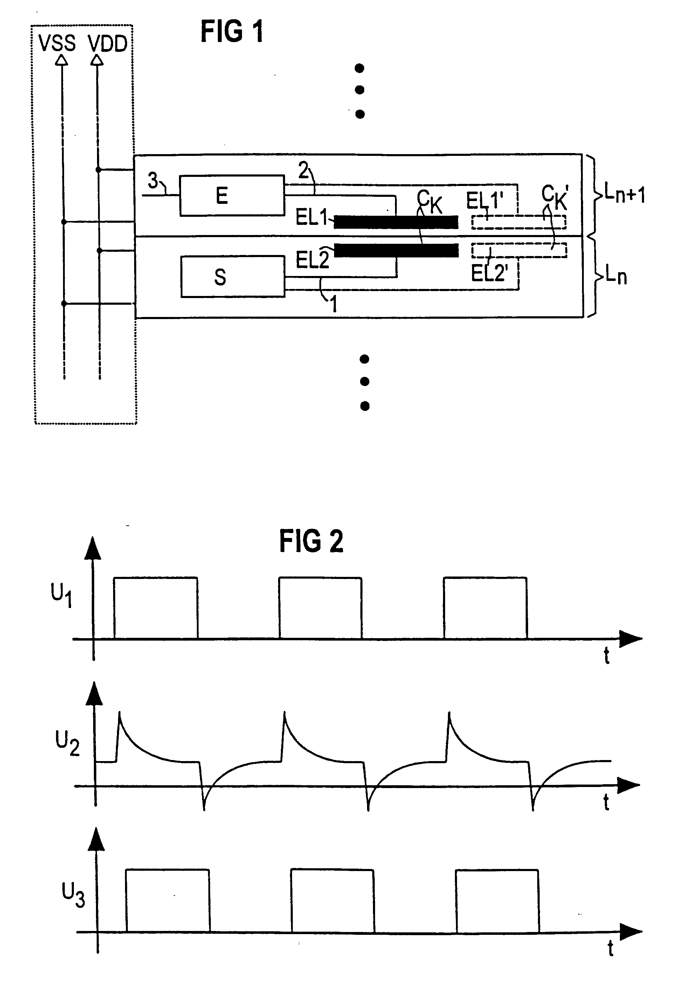

In Figur 1 sind zwei benachbarte Chiplagen Lₙ und Lₙ₊₁ einer VIC dargestellt, wobei die Chiplage Lₙ eine Sendeeinrichtung S enthält, die an ihrem Ausgang 1 mit einer Elektrode EL2 einer Koppelkapazität C_{K} verbunden ist und wobei die Chiplage Lₙ₊₁ die zugehörige Gegenelektrode EL1 der Koppelkapazität C_{K} enthält, die mit einem Ausgang 2 einer Empfangseinrichtung E verbunden ist, die sich ihrerseits in der Chiplage Lₙ₊₁ befindet und einen Ausgang 3 aufweist. Sowohl die Chiplage Lₙ als auch die Chiplage Lₙ₊₁ bzw. die darin enthaltenen Schaltungen sind jeweils über Seitenwandkontaktierungen mit Versorgungsspannungsleitungen VDD und VSS verbunden. Bei der Koppelkapazität C_{K} handelt es sich um eine definiert vorgesehene Kapazität, also nicht nur um keine gegebenenfalls parasitär auftretende Kapazität.

Darüberhinaus besteht prinzipiell auch die Möglichkeit, daß die Elektroden der Koppelkapazität nicht nur in benachbarten Chiplagen, sondern in weiter voneinander entfernten Chiplagen vorgesehen sind, wobei jedoch entsprechend große Koppelkapazitäten nur mit größeren Elektrodenflächen zu erzeugen sind.

Die Zuordnung der Sendeeinrichtung S und der Empfangseinrichtung E zu den Chiplagen Lₙ und Lₙ₊₁ ist für die Erfindung selbst unerheblich und kann auch so ausgestaltet sein, daß die Empfangseinrichtung E sich in der Chiplage Lₙ und die Sendeeinrichtung S sich in der Chiplage Lₙ₊₁ befindet.

Ferner ist in Figur 1 eine optional vorsehbare weitere Koppelkapazität C'_{K} gestrichelt eingezeichnet, die eine mit der Empfangseinrichtung E verbundene Elektrode EL1' und eine mit der Sendeeinrichtung S verbundene weitere Elektrode EL2' aufweist.

In Figur 2 ist in einem dreifachen Spannungs/Zeitdiagramm ist über der Zeitachse eine rechteckförmige Spannung U₁ dargestellt, die am Ausgang 1 der Sendeeinrichtung S anliegt. Ferner ist über der zweiten Zeitachse des Dreifachdiagramms eine Spannung U₂ dargestellt, die am Eingang 2 der Empfangseinrichtung E anliegt. Diese Spannung U₂ weist einen von Null verschiedenen Gleichspannungsanteil auf, dem eine Spannung überlagert ist, die im zeitlichen Bereich der Signalflanken von U₁ weitgehend einer zeitlichen Differentiation der Spannung U₁ entspricht, wobei die Signalflanken der Spannung U₁ stark betont sind und jeweils ein nahezu exponentieller Abfall bzw. Anstieg zum Gleichspannungsanteil erfolgt. Das dritte Spannungs/Zeitdiagramm zeigt eine Spannung U₃ am Ausgang 3 der Empfangseinrichtung E, die die rechteckförmige Signalform der Spannung U₁ aufweist.

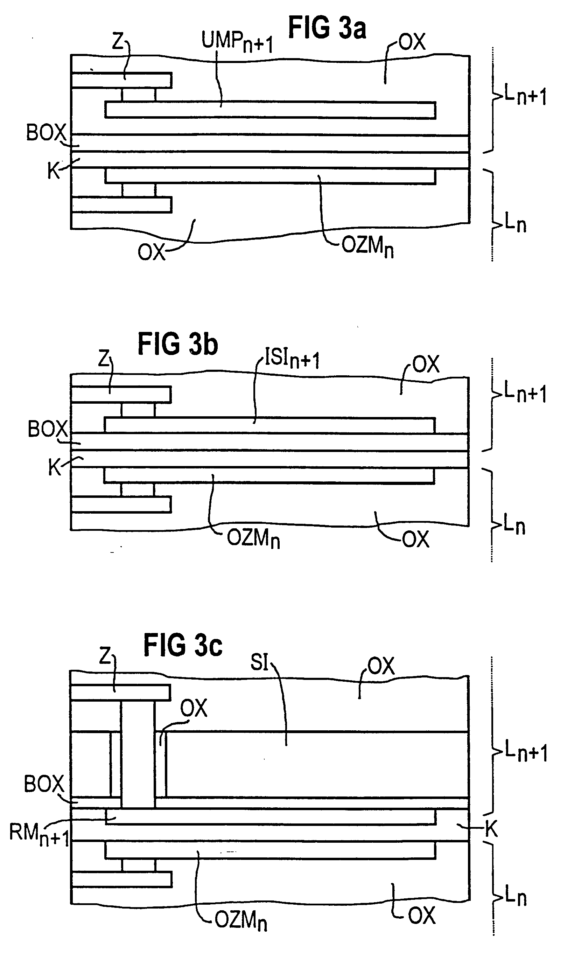

Im folgenden sind in den Figuren 3a, 3b und 3c verschiedene Ausgestaltungsformen der Koppelkapazität C_{K} bzw. gegebenenfalls auch der weiteren Koppelkapazität C_{K}' dargestellt. Bei allen drei Ausführungsformen besteht jeweils die untere Elektrode aus einer oberen bzw. zusätzlichen Metallschicht OZMₙ der unteren Chiplage. Bis auf einen Kontaktierungsbereich ist die aus der Metallschicht OZMₙ gebildete Elektrode gegenüber darunterliegenden Schichten und zur Seite hin durch ein Oxid OX isoliert. Die Chiplage Lₙ kann dabei aus einem sogenannten SOI-Wafer (silicon on insulator wafer) oder einem gewöhnlichen Silizium-Wafer hergestellt werden. Die Chiplage Lₙ₊₁ wird jeweils über eine Kleberschicht K mit der darunterliegenden Chiplage Lₙ mechanisch verbunden, wobei die Kleberschicht K in allen drei Fällen ein Dielektrikum für die jeweilige Koppelkapazität C_{K} bzw. C'_{K} bildet. Bei der in den Figuren 3a und 3b dargestellten Anordnung handelt es sich bei der Chiplage Lₙ₊₁ jeweils um einen gedünnten SOI-Wafer, dessen vergrabenes Oxid BOX jeweils über eine Kleberschicht K mit der Metallschicht OZMₙ der darunterliegenden Chiplage Lₙ verbunden ist. Bei der in Figur 3a dargestellten Anordnung besteht die Elektrode der Chiplage Lₙ₊₁ aus der untersten leitfähigen Schicht UMPₙ₊₁, die beispielsweise aus Metall oder Polysilizium besteht und die bis auf eine Zuleitung Z von einem Oxid OX umschlossen ist. Das Dielektrikum der Koppelkapazität wird also im Falle der Figur 3a aus dem Oxid OX, dem vergrabenen Oxid BOX und der Kleberschicht gebildet. Möglicherweise vorhandene zusätzliche Passivierungs- und Oxidschichten der unteren Chiplage Lₙ sind in den Figuren 3a bis 3c vernachlässigt.

Um den Abstand der beiden Elektroden zu verringern, kann, wie in Figur 3b dargestellt, auch alternativ zur Ausführungsform von Figur 3a direkt ein inselförmiges dotiertes Siliziumgebiet ISIₙ₊₁ als Elektrode EL1 verwendet werden.

Als weitere Alternative kann, wenn, wie in Figur 3c gezeigt, die Chiplage Lₙ₊₁ aus einem SOI-Wafer mit einer verhältnismäßig dicken verbleibenden Siliziumschicht SI besteht, dadurch gebildet werden, daß auf der Rückseite der Siliziumschicht SI durch eine isolierende Oxidschicht OX von der Siliziumschicht SI getrennt eine rückseitige Metallschicht RMₙ₊₁ aufgebracht ist. Hierbei erfolgt eine Verbindung der Elektrode mit der Zuleitung Z dadurch, daß die Siliziumschicht SI durchbrochen wird und eine metallische Durchkontaktierung ausgeführt wird, die durch eine Oxidschicht von der Siliziumschicht SI getrennt ist. Das Dielektrikum der Koppelkapazität besteht bei dieser Ausführungsform lediglich aus der Kleberschicht K, wodurch die beiden Elektroden der Koppelkapazität vergleichsweise dicht beieinander liegen. Gerade bei der letzteren Ausführungsform von Figur 3c kann es dabei leicht zu einer Berührung der beiden Elektroden kommen, was jedoch unkritisch ist, da es lediglich auf eine zuverlässige elektrische Verbindung zwischen Schaltungsteilen beider Chiplagen ankommt.

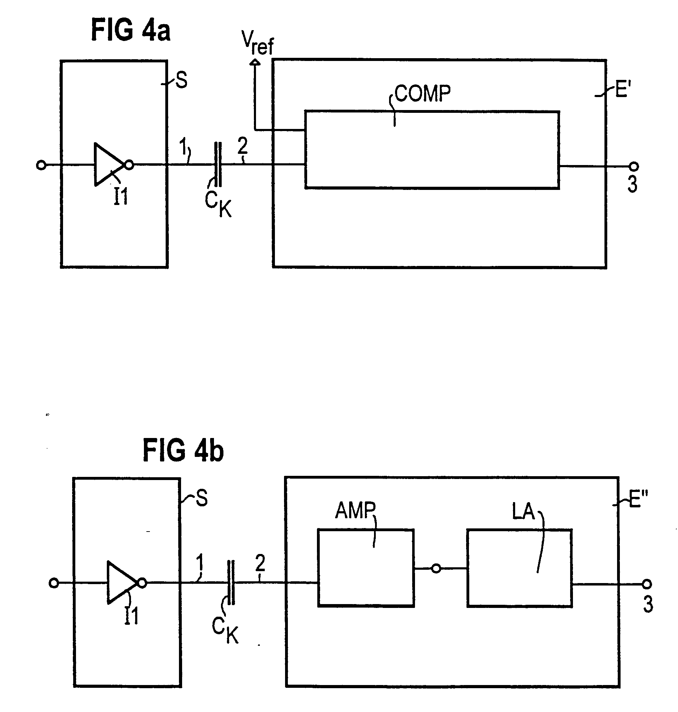

In den Figuren 4a und 4b sind die Blockschaltbilder zweier alternativer Ausführungsformen E' und E'' der Empfangseinrichtung E zusammen mit der Sendeeinrichtung S und der Koppelkapazität C_{K} dargestellt. Die Sendeeinrichtung S besteht dabei in beiden Fällen aus einem Inverter I1, dessen Ausgang gleichzeitig den Ausgang 1 der Sendeeinrichtung S bildet, der seinerseits über die Koppelkapazität C_{K} mit dem Eingang 2 der jeweiligen Empfangseinrichtung E' bzw. E'' verbunden ist.

Bei der in Figur 4a dargestellten Empfangseinrichtung E' handelt es sich um einen Komparator COMP mit Hysterese. Das Signal am Eingang 2 wird hierbei mit einer Referenzgleichspannung V_{ref} verglichen und der Zustand am Ausgang 3 der Empfangseinrichtung E' durch die Hysterese gehalten.

Die in Figur 4b dargestellte alternative Empfangseinrichtung E'' weist einen Eingang 2 auf, der mit einem Eingang eines Vorverstärkers AMP verbunden ist, dessen Ausgang mit einem Halteglied LA verbunden ist, welches das Signal am Ausgang 3 konstant hält, wenn gerade kein Impuls am Eingang 2 auftritt.

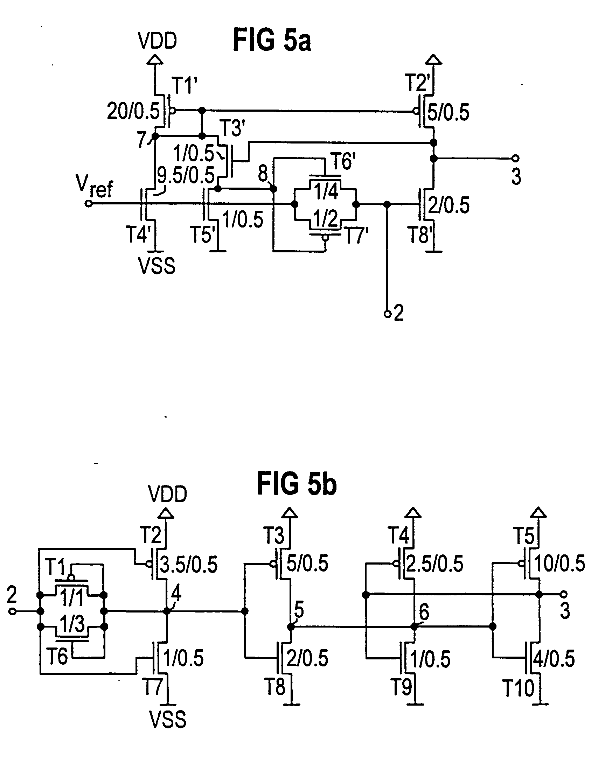

In Figur 5a ist eine vollständige in CMOS-Technik realsierte Empfangseinrichtung E' mit einem Komparator mit Hysterese dargestellt, die 8 MOS-Feldeffekttransistoren T1'...T8' aufweist. Die Transistoren T1', T2' und T7' sind p-Kanal-Feldeffekttransistoren und die Transistoren T3'...T6' und T8' sind n-Kanal-Feldeffekttransistoren. Die Transistoren T2' und T8' sind in Reihe geschaltet und liegen zwischen den Versorgungsspannungen VDD und VSS, wobei ihr Verbindungspunkt den Ausgang 3 der Empfangseinrichtung E' darstellt. Der Gateanschluß des Transistors T8' ist mit dem Eingang 2 der Empfangseinrichtung E' und über die Transistoren T6' und T7' mit der Referenzspannung V_{ref} verbunden, wobei die Gateanschlüsse der Transistoren T6' und T7' mit einem Verbindungsknoten der Transistoren T3' und T5' verbunden sind. Der Transistor T1' ist mit dem Transistor T4' in Reihe geschaltet und die Reihenschaltung der beiden Transistoren T1' und T4' liegt zwischen den Versorgungsspannungen VDD und VSS. Die beiden Gateanschlüsse der Transistoren T1' und T2' sind mit dem Verbindungspunkt 7 zwischen den beiden Transistoren T1' und T4' und über den Transistor T3' mit dem Knoten 8 verbunden, wobei der Gateanschluß des Transistors T3' mit dem Ausgang 3 beschaltet ist und der Knoten 8 über den Transistor T8' mit der Versorgungsspannung VSS verbunden ist.

Die Transistoren T4', T5' und T8' sind im statischen Betrieb im Prinzip als Stromquellen geschaltet. Die Transistoren T1' und T2' bilden einen Stromspiegel. Die Hysterese wird durch Ein- und Ausschalten der durch den Transistor T5' gebildeten Stromquelle-in Abhängigkeit des Ausgangssignals realisiert, wobei der Transistor T3' durch einen am Ausgang 3 anliegenden Lowpegel gesperrt ist, wodurch wiederum der zum Transistor T2' gespiegelte Strom so klein ist, daß der Transistor T8' im linearen Bereich mit kleiner Drain-Source-Spannung betrieben wird und der Ausgangspegel niedrig bleibt. Analog wird auch ein High-Pegel am Ausgang 3 gehalten. Im dynamischen Betrieb entkoppeln die Transistoren T6' und T7', die ein Transfergate bilden, die Referenzspannung V_{ref} vom Eingangssignal 2. Ein über die Koppelkapazität eingespeister Signalpuls löst einen Umschaltvorgang der Schaltung aus. Die Schaltungen arbeiten mit einem CMOS-Pegel und der Komparator wird zusätzlich mit einer Referenzgleichspannung V_{ref} versorgt, die ca. 1 Volt beträgt. Diese Referenzgleichspannung V_{ref} kann dabei beispielsweise über einen Stromspiegel realisiert werden. Die Kanalweiten der Transistoren T1'...T8' betragen der Reihe nach beispielsweise 20 µm, 5 µm, 1 µm, 9,5 µm, 1 µm, 1 µm, 1 µm und 2 µm. Die Kanallänge des Transistors T6' beträgt beispielsweise 4 µm, die Kanallänge des Transistors T7' beispielsweise 2 µm und die Kanallänge der restlichen Transistoren T1'...T5' sowie des Transistors T8' betragen jeweils beispielsweise 0,5 µm. Als Sendeeinrichtung S kann ein einfacher Inverter mit einem n-Kanal-Transistor, der beispielsweise eine Kanalweite von 2 µm und eine Kanallänge von 0,5 µm aufweist und einen p-Kanal-Transistor der eine Kanalweite von beispielsweise 5 µm und eine Kanallänge von beispielsweise 0,5 µm aufweist realisiert werden.

Eine vollständig in CMOS-Technik realisierte Empfangseinrichtung E'' mit einem Halteglied und einem Vorverstärker ist in Figur 5b dargestellt und besteht aus 10 MOS-Feldeffekttransistoren T1...T10. Dabei sind die MOS-Feldeffekttransistoren T1...T5 p-Kanal-Feldeffekttransistoren und die Transistoren T6...T10 n-Kanal-Feldeffekttransistoren. Die Transistorpaare T2 und T7, T3 und T8, T4 und T9 sowie T5 und T10 sind jeweils paarweise als Inverter in Reihe geschaltet und liegen zwischen den Versorgungsspannungen VDD und VSS. Der Eingang 2 der Empfangseinrichtung E'' ist mit dem Gate des Transistors T2, dem Gate des Transistors T7 sowie über den Transistor T1 und den Transistor T6 mit dem Verbindungspunkt 4 der beiden Transistoren T2 und T7 verbunden, wobei die Gateanschlüsse der Transistoren T1 und T6 ebenfalls mit dem Verbindungspunkt 4 der beiden Transistoren T2 und T7 verbunden ist. Der Verbindungspunkt 4 zwischen den beiden Transistoren T2 und T7 ist sowohl mit dem Gateanschluß des Transistors T3 als auch dem Gateanschluß des Transistors T8 beschaltet. Der Verbindungspunkt 5 zwischen den beiden Anschlüssen der Transistoren T3 und T8 ist mit dem Verbindungspunkt 6 der beiden Transistoren T4 und T9 beschaltet und mit den Gateanschlüssen der Transistoren T5 und T10 verbunden. Der Verbindungspunkt zwischen den Transistoren T5 und T10 stellt den Ausgang 3 der Empfangseinrichtung E'' dar und ist mit dem Gateanschluß des Transistors T4 und dem Gateanschluß des Transistors T9 verbunden. Der aus den Transistoren T2 und T7 gebildete Inverter wird mit den als Transfergate geschalteten Transistoren T1 und T6 als gegengekoppelte Verstärkerstufe betrieben. Diese bildet zusammen mit der Koppelkapazität C_{K} einen Differenzierer. Die obere Grenzfrequenz wird durch die Gatekapazität der Transistoren T1, T2, T6 und T7 bestimmt. Dies verhindert ein Einkoppeln hochfrequenter Störsignale. Bei einem eintreffenden Signalpuls am Eingang 2 der Schaltung verstärkt der Inverter aus den Transistoren T3 und T8 das Signal nochmals, so daß das Halteglied, das aus den Transistoren T4, T5, T9 und T10 besteht, zum Umschalten gebracht wird.

Die Kanalweiten der Transistoren T1...T10, können der Reihe nach 1 µm, 3,5 µm, 5 µm, 2,5 µm, 10 µm, 1 µm, 1 µm, 2 µm, 1 µm und 4 µm gewählt werden. Die Kanallänge des Transistors T1 kann beispielsweise 1 µm und die Kanallänge des Transistors T6 3 µm sowie die restlichen Kanallängen jeweils 0,5 µm gewählt werden.

Bei einem Elektrodenabstand von beispielsweise 1 µm beträgt die Koppelkapazität bei einer Elektrodenfläche von 1000 µm² etwa 30 fF. Die Funktion der Schaltung wurde für Koppelkapazitäten bis herunter zu 5 fF bis in den Bereich mehrerer hundert MHz verifiziert.

Eine Reduktion der Koppelkapazität kann im Falle einer komplementären Signalübertragung und differentieller Auswertung erreicht werden. Auch kleine Lufteinschlüsse und Variationen des Elektrodenabstandes beeinträchtigen die Funktion der Signalübertragung zwischen den Chiplagen der VIC's nicht.

## Patentansprüche

1. Verfahren zur Herstellung einer Anordnung zur Signalübertragung zwischen Chiplagen einer vertikal integrierten Schaltung ,
bei der eine Koppelkapazität (C_{K}) zur definierten kapazitiven Signalübertragung zwischen einem Teil der Schaltung in einer Chiplage (Lₙ₊₁) und einem weiteren Teil der Schaltung in einer weiteren Chiplage (Lₙ) vorgesehen ist,
bei der in der Chiplage (Lₙ₊₁) eine Empfangseinrichtung (E) und in der weiteren Chiplage (Lₙ) eine Sendeeinrichtung (S) vorgesehen sind, die über die Koppelkapazität miteinander verkoppelt sind,
bei der die Koppelkapazität (C_{K}) eine erste und zweite lateral ausgebildete Elektrode aufweist, wobei die erste Elektrode (EL1) einen Bestandteil der Chiplage (Lₙ₊₁) und die zweite Elektrode (EL2) einen Bestandteil der weiteren Chiplage (Lₙ) bildet und beide Elektroden voneinander elektrisch isoliert sind, und
bei der mindestens eine Versorgungsgleichspannung für mindestens einen Schaltungsteil des in der Chiplage (Lₙ₊₁) befindlichen Teiles der vertikal integrierten Schaltung dadurch gebildet ist, daß über die Koppelkapazität (C_{K}) eine Versorgungswechselspannung aus der weiteren Chiplage (Lₙ) kapazitiv in die erste Chiplage (Lₙ₊₁) übertragen und dort anschließend durch eine in der ersten Chiplage befindliche Gleichrichterschaltung gleichgerichtet ist
**dadurch gekennzeichnet,**
**daß** mindestens eine Chiplage (Lₙ₊₁) durch dünnen eines SOI-Wafer (Silicon on Insulator Wafer) gebildet wird,
**daß** auf eine vergrabene Oxidschicht (BOX) des gedünnten SOI-Wafers der mindestens einen Chiplage der Reihe nach mehrere Schichten aufgebracht werden und aus der ersten leitfähigen Schicht dieser Schichten die erste und gegebenenfalls auch die weitere erste Elektrode (EL1,EL1') erzeugt wird, wobei die erste leitfähige Schicht aus einer Polysiliziumschicht oder Metallschicht (UMPₙ₊₁) oder eigens aus einem inselförmigen, stark dotierten Siliziumgebietes (ISIₙ₊₁) besteht und daß eine weitere Chiplage (Lₙ) der Reihe nach aus mehreren Schichten aufgebaut wird und die zweite und gegebenenfalls auch die weitere zweite Elektrode (EL2,EL2') durch eine auf die zweite Chiplage zuletzt aufgebebrachten Metallschicht (OZMₙ) gebildet wird.

## Claims

1. Method for fabricating an arrangement for signal transfer between chip layers of a vertically integrated circuit,
in which provision is made for a coupling capacitance (C_{K}) for the defined capacitive signal transfer between one part of the circuit in a chip layer (Lₙ₊₁) and a further part of the circuit in a further chip layer (Lₙ),
in which a receiving device (E) is provided in the chip layer (Lₙ₊₁) and a transmitting device(S) is provided in the further chip layer (Lₙ), which devices are coupled to one another via the coupling capacitance,
in which the coupling capacitance (C_{K}) has a first and a second laterally designed electrode, the first electrode (EL1) forming a constituent part of the chip layer (Lₙ₊₁) and the second electrode (EL2) forming a constituent part of the further chip layer (Lₙ) and both electrodes being electrically insulated from one another, and
in which at least one DC supply voltage for at least one circuit part of that part of the vertically integrated circuit which is situated in the chip layer (Lₙ₊₁) is formed by an AC supply voltage being capacitively transferred from the further chip layer (Lₙ) via the coupling capacitance (C_{K}) into the first chip layer (Lₙ₊₁), where it is subsequently rectified by a rectifier circuit situated in the first chip layer,
**characterized**
**in that** at least one chip layer (Lₙ₊₁) is formed by thinning an SOI wafer (Silicon on Insulator Wafer),
**in that** a plurality of layers are applied, in order, to a buried oxide layer (BOX) of the thinned SOI wafer of the at least one chip layer and the first and, if appropriate, also the further first electrode (EL1, EL1') are produced from the first conductive layer of the said layers, the first conductive layer comprising a polysilicon layer or metal layer (UMPₙ₊₁) or specially an insular, heavily doped silicon region (ISIₙ₊₁), and
**in that** a further chip layer (Lₙ) is constructed from a plurality of layers, in order, and the second and, if appropriate, also the further second electrode (EL2, EL2') are formed by a metal layer (OZMₙ) applied last to the second chip layer.

## Revendications

1. Procédé de fabrication d'un dispositif de transmission de signaux entre des strates de puce d'un circuit intégré verticalement,
dans lequel il est prévu une capacité (C_{K}) de couplage pour la transmission capacitive de signaux d'une manière définie entre une partie du circuit dans une strate (Lₙ₊₁) de la puce et une autre partie du circuit dans une autre strate (Lₙ) de la puce,
dans lequel il est prévu dans la strate (Lₙ₊₁) de la puce un dispositif (E) de réception et dans l'autre strate (Lₙ) de la puce un dispositif (S) d'émission, qui sont couplés l'un à l'autre par la capacité de couplage,
dans lequel la capacité (C_{K}) de couplage comporte une première et une deuxième électrode constituées latéralement, la première électrode (EL1) formant un élément constitutif de la strate (Lₙ₊₁) de la puce et la deuxième électrode (EL2) formant un élément constitutif de l'autre strate (Lₙ) de la puce et les deux électrodes étant isolées électriquement l'une de l'autre, et
dans lequel au moins une tension continue d'alimentation pour au moins une partie de la partie du circuit intégré verticalement, qui se trouve dans la strate (Lₙ₊₁) de la puce, est formée par le fait qu'il est transmis capacitivement par la capacité (C_{K}) de couplage une tension alternative d'alimentation, de l'autre strate (Lₙ) de la puce à la première strate (Lₙ₊₁) de la puce, et qu'elle y est redressée ensuite par un circuit redresseur se trouvant dans la première strate de la puce,
**caractérisé**
**en ce qu'**au moins une strate (Lₙ₊₁) de la puce est formée en amincissant une pastille SOI (Silicon on Insulator Wafer),
**en ce que** sur une couche (BOX) d'oxyde enterrée de la pastille SOI amincie de la au moins une strate de la puce sont disposées dans l'ordre plusieurs couches et il est produit dans la première couche conductrice de ces couches la première et, le cas échéant également, l'autre première électrode (EL1, EL1'), la première couche conductrice étant constituée d'une couche de polysilicium ou d'une couche en métal (UMPₙ₊₁) ou d'une manière propre d'un domaine (ISIₙ₊₁) en silicium en forme d'îlot fortement dopé et en ce qu'une autre strate (Lₙ) de la puce est formée dans l'ordre de plusieurs couches et la deuxième et, le cas échéant également, l'autre deuxième électrode (EL2, EL2') est formée par une couche métallique déposée en dernier sur la deuxième strate de la puce.
